(19) Europäisches Patentamt
European Patent Office
Office européen des brevets

(11) **EP 4 772 893 A1**

(12) **EUROPEAN PATENT APPLICATION**
published in accordance with Art. 153(4) EPC

(43) Date of publication:
**08.07.2026 Bulletin 2026/28**

(21) Application number: **23953078.5**

(22) Date of filing: **22.09.2023**

(51) International Patent Classification (IPC):
***G01R 31/12*** (2020.01)   ***G01R 31/34*** (2020.01)

(52) Cooperative Patent Classification (CPC):
**G01R 31/12; G01R 31/34**

(86) International application number:
**PCT/JP2023/034386**

(87) International publication number:
**WO 2025/062596 (27.03.2025 Gazette 2025/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **TMEIC Corporation**
**Tokyo 104-0031 (JP)**

(72) Inventors:
• **YAMANAKA, Yuta**
**Tokyo 100-8310 (JP)**

• **UMEMOTO, Takahiro**
**Tokyo 100-8310 (JP)**
• **OKAMOTO, Tetsushi**
**Tokyo 104-0031 (JP)**
• **IKEDA, Ryuji**
**Tokyo 104-0031 (JP)**
• **KIKUTA, Shinsuke**
**Tokyo 104-0031 (JP)**
• **SAKURAI, Takayuki**
**Tokyo 104-0031 (JP)**

(74) Representative: **TBK**
**Bavariaring 4-6**
**80336 München (DE)**

(54) **INSULATOR DETERIORATION DIAGNOSING DEVICE, INSULATOR DETERIORATION DIAGNOSING SYSTEM, AND INSULATOR DETERIORATION DIAGNOSING METHOD**

(57)     An insulator deterioration diagnosing device includes: a calculating unit (102) to calculate, from an electric signal based on an output of a sensor of a single type to measure a current flowing through a conductor of an electric device including an insulator, discharge power of the electric device; and a diagnosing unit (105) to diagnose a deterioration state of the insulator on the basis of the calculated discharge power.

FIG. 1

EP 4 772 893 A1

**Description**

TECHNICAL FIELD

The present disclosure relates to an insulator deterioration diagnosing technique.

BACKGROUND ART

In an electric device such as a rotary machine, a failure of an electric device may be caused due to progress of deterioration of an insulator to be used. In order to prevent a failure of an electric device in advance, it is important to grasp a deterioration state of an insulator and perform maintenance of the electric device in such a way that the electric device can be safely operated for a long period of time. As for a deterioration diagnosing technique for an insulator of a rotary machine, for example, there is a technique disclosed in Patent Literature 1.

CITATION LIST

PATENT LITERATURE

Patent Literature 1: JP 2022-38676 A

SUMMARY OF INVENTION

TECHNICAL PROBLEM

An insulation deterioration diagnosing device disclosed in Patent Literature 1 has a problem that it is necessary to measure a plurality of physical quantities using a plurality of types of sensors such as a temperature detection means, a water vapor amount acquisition means, and a gas measurement means.
The present disclosure has been made to solve such a problem, and an object thereof is to provide an insulator deterioration diagnosing technique capable of diagnosing deterioration of an insulator of an electric device with a simple configuration in which the number of types of sensors is smaller.

SOLUTION TO PROBLEM

An aspect of an insulator deterioration diagnosing device according to an embodiment of the present disclosure includes: a calculating unit to calculate, from an electric signal based on an output of a sensor of a single type to measure a current flowing through a conductor of an electric device including an insulator, discharge power of the electric device; and a diagnosing unit to diagnose a deterioration state of the insulator on the basis of the calculated discharge power.

ADVANTAGEOUS EFFECTS OF INVENTION

According to an insulator deterioration diagnosing device according to an embodiment of the present disclosure, it is possible to diagnose deterioration of an insulator of an electric device with a simple configuration in which the number of types of sensors is smaller.

BRIEF DESCRIPTION OF DRAWINGS

FIG. 1 is a diagram illustrating a configuration example of an insulator deterioration diagnosing device and an insulator deterioration diagnosing system.
FIG. 2 is a partial cross-sectional view of a rotary machine.
FIG. 3 is a diagram illustrating a configuration example of a circuit of a measuring system provided in the insulator deterioration diagnosing system.
FIG. 4A is a diagram illustrating a configuration example of hardware of the insulator deterioration diagnosing device.
FIG. 4B is a diagram illustrating a configuration example of hardware of the insulator deterioration diagnosing device.
FIG. 5 is a flowchart of an insulator deterioration diagnosing method.
FIG. 6 is a diagram illustrating a relationship between discharge power and a deterioration state.

DESCRIPTION OF EMBODIMENTS

Hereinafter, various embodiments of the present disclosure are described in detail with reference to the accompanying drawings. Note that, in the drawings, the same or similar portions are denoted by the same or similar reference signs, and redundant description of such portions is omitted. In the present disclosure, the term "or" is used in the meaning of a comprehensive logical sum unless otherwise stated.

It is generally known that an insulator of an electric device deteriorates due to partial discharge. An insulator deterioration diagnosing technique according to the present disclosure diagnoses a deterioration state of an insulator of a rotary machine on the basis of information on discharge power of partial discharge to which the insulator is exposed. This will be hereinafter described in further detail.

First Embodiment

<Configuration>

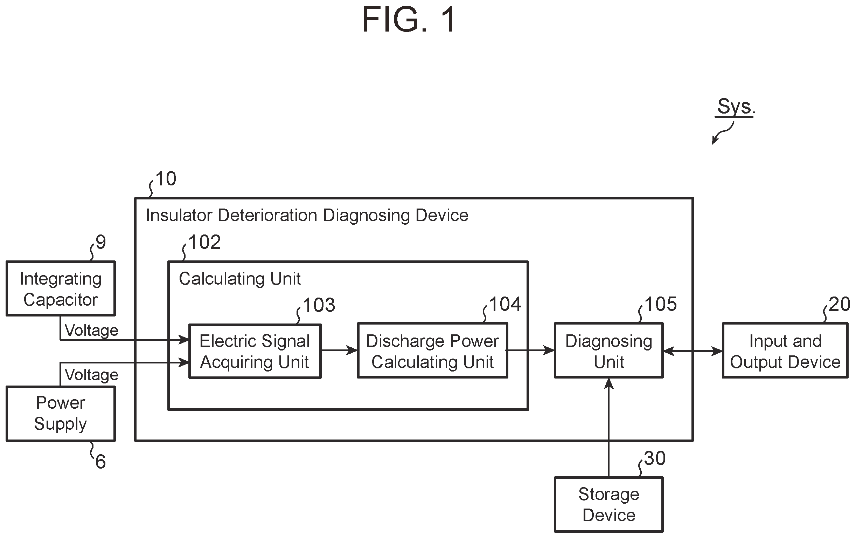

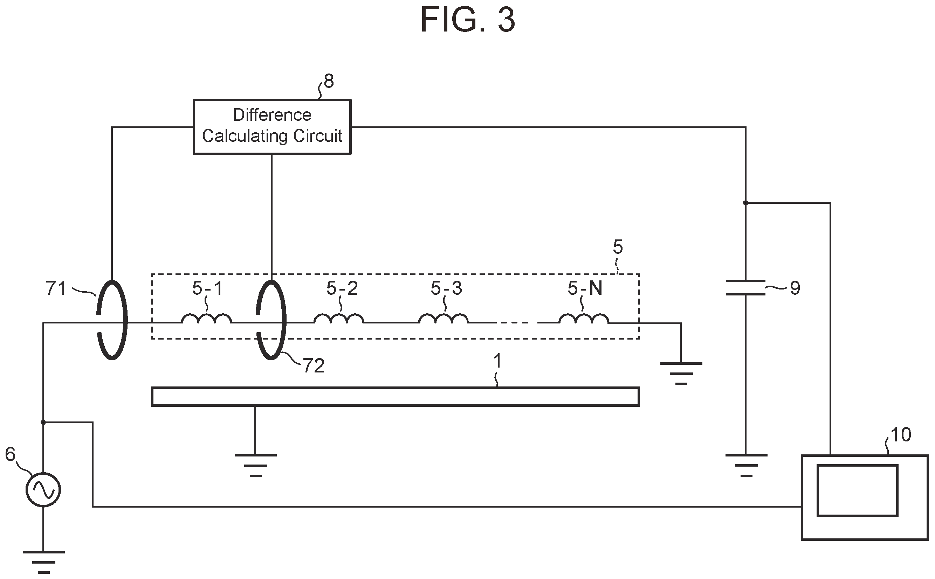

Configurations of an insulator deterioration diagnosing device and an insulator deterioration diagnosing system will be described with reference to FIG. 1. FIG. 1 is a diagram illustrating a configuration example of an insulator deterioration diagnosing device 10 and an insulator deterioration diagnosing system Sys. As illustrated in FIG. 1, the insulator deterioration diagnosing system Sys. is provided with, as an example, a power supply 6 that supplies AC power to an electric device that is a target of an insulator deterioration diagnosis, an integrating capacitor 9, the insulator deterioration diagnosing device 10, an input and output device 20, and a storage device 30. A voltage of the power supply 6 and a voltage of the integrating capacitor 9 are input as electric signals to the insulator deterioration diagnosing device 10. The power supply 6 and the integrating capacitor 9 are elements forming a measuring system of the insulator deterioration diagnosing system Sys. A detailed configuration example of the measuring system will be described later with reference to FIG. 3.

(Input and Output Device)

The input and output device 20 is provided with an input device that receives an operation instruction from an operator, and a display device that displays a diagnostic result by text, an image or the like. Examples of the input device include a keyboard or a mouse. Examples of the display device include a liquid crystal display device or an organic electro luminescence (EL) display. The input and output device 20 may be a display with touch panel integrally provided with the input device and display device.

(Storage Device)

The storage device 30 is a known storage medium that holds a program or data related to processing of the insulator deterioration diagnosing device 10. As an example, the storage device 30 stores discharge deterioration relationship data to be described later.

(Insulator Deterioration Diagnosing Device)

As illustrated in FIG. 1, the insulator deterioration diagnosing device 10 is provided with a calculating unit 102 and a diagnosing unit 105.

(Calculating Unit)

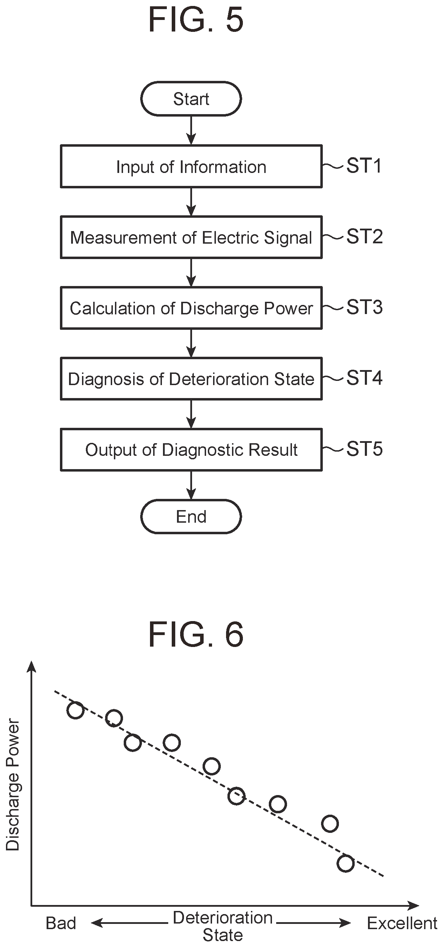

The calculating unit 102 is provided with an electric signal acquiring unit 103 and a discharge power calculating unit 104. The electric signal acquiring unit 103 is a functional unit that acquires the voltage of the power supply 6 and the voltage of the integrating capacitor 9. The electric signal acquiring unit 103 supplies the voltage of the power supply 6 and the voltage of the integrating capacitor 9 that are acquired to the discharge power calculating unit 104. The discharge power calculating unit 104 calculates discharge power to be measured from the voltage of the power supply 6 and the voltage of the integrating capacitor 9. A method of calculating the discharge power will be described later with reference to a flowchart of FIG. 5. The discharge power calculating unit 104 supplies the calculated discharge power to the diagnosing unit 105.

(Diagnosing Unit)

The diagnosing unit 105 receives the discharge power calculated by the discharge power calculating unit 104 from the discharge power calculating unit 104. The diagnosing unit 105 acquires, from the storage device 30, discharge deterioration relationship information corresponding to the insulator to be diagnosed out of the discharge deterioration relationship data stored in advance in the storage device 30. The discharge deterioration relationship data is data representing a relationship between the discharge power and a deterioration state of an insulating material as illustrated in FIG. 6. The storage device 30 stores the discharge deterioration relationship data in accordance with characteristics such as a material or a thickness of the insulator, and the diagnosing unit 105 acquires the discharge deterioration relationship data corresponding to the insulator to be diagnosed as the discharge deterioration relationship information. Note that, the discharge deterioration relationship data may be represented in a table form or by a formula. The diagnosing unit 105 diagnoses the deterioration state of the insulator to be diagnosed from the received discharge power and the acquired discharge deterioration relationship information. The diagnosing unit 105 outputs a result of diagnosis to the input and output device 20, and the diagnostic result is displayed by the input and output device 20.

(Measuring System)

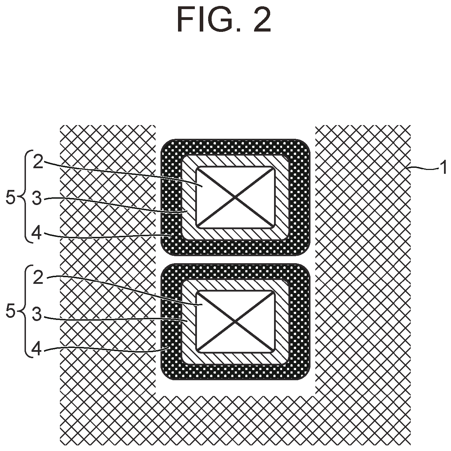

Next, the measuring system of the insulator deterioration diagnosing system Sys. will be described with reference to FIGS. 2 and 3. FIG. 2 is a partial cross-sectional view of a rotary machine as an example of an electric device. More specifically, FIG. 2 is a cross-sectional view of a slot portion of a stator core of the rotary machine. FIG. 3 is a diagram illustrating a configuration example of a circuit of the measuring system of the insulator deterioration diagnosing system Sys. More specifically, FIG. 3 illustrates a measuring circuit of an electric signal for acquiring discharge power of a stator coil group for one phase of the rotary machine.

As illustrated in FIGS. 2 and 3, the measuring system of the insulator deterioration diagnosing system Sys. is provided with the power supply 6 that supplies AC power to the rotary machine, an optical CT 71 (first optical CT) that measures an inflow current flowing into a site to be measured of the rotary machine, an optical CT 72 (second optical CT) that measures an outflow current flowing out from the site to be measured, a difference calculating circuit 8 that is connected to the optical CT 71 and the optical CT 72 and outputs an electric signal corresponding to a difference between the inflow current flowing into the site to be measured and the outflow current flowing out from the site to be measured, and the integrating capacitor 9 connected between an output of the difference calculating circuit 8 and the ground. As illustrated in FIG. 3, the insulator deterioration diagnosing device 10 is connected to a connection line (first connection line) to which the AC power is supplied from the power supply 6 and a connection line (second connection line) that connects the difference calculating circuit 8 and the integrating capacitor 9.

As illustrated in FIG. 2, the stator core 1 is provided with a slot. A stator coil 5 including a stator coil conductor 2, a stator coil insulating member 3, and a stator coil insulating film 4 that prevents corona discharge is accommodated in the slot. In such a structure, when there is a gap between the stator coil insulating film 4 and the stator core 1, partial discharge is generated starting from the gap. Hereinafter, a method of diagnosing the stator coil insulating film 4 deteriorated by the partial discharge of the gap will be described on the basis of a case where an example of the insulator is the stator coil insulating film 4.

In FIG. 3, the stator core 1 is set at ground potential. The stator coil 5 is formed by connecting N stator coils including a stator coil 5-1, a stator coil 5-2, a stator coil 5-3,..., and a stator coil 5-N in series, and one end of the stator coils 5 is connected to the power supply 6. The stator coil 5 is applied with a voltage from the power supply 6 and thus has a high voltage. The other end of the stator coils 5 is grounded. The partial discharge that deteriorates the stator coil insulating film 4 is generated between the stator core 1 and the stator coil 5.

As an example, measurement of the electric signal for calculating, by the discharge power calculating unit 104, the discharge power of the partial discharge generated between the stator coil 5-1 located closest to the power supply 6 out of the stator coils 5-1 to 5-N forming the stator coil 5 and the stator core 1 will be described. Note that, the term "located closer" as used herein means that it is electrically connected to the power supply 6 at a closer position, that is, it is directly connected to the power supply 6 without intervention of another stator coil.

The current flowing through the stator coil 5 flows through the stator coil 5-1, the stator coil 5-2, and the stator coil 5-3 in this order, and further flows through the stator coil 5-N to flow to a grounding site. At that time, when the partial discharge is generated between the stator coil 5-1 and the stator core 1, a discharge current flows from the stator coil 5-1 to the stator core 1. This discharge current is equal to a difference between a current flowing from the power supply 6 into the stator coil 5-1 and a current flowing out of the stator coil 5-1 to the stator coil 5-2. Therefore, the current flowing into the stator coil 5-1 is measured using the optical CT 71, and the current flowing out of the stator coil 5-1 to the stator coil 5-2 is measured using the optical CT 72.

The optical current transformer (CT) is a sensor for detecting a current, including an optical fiber and a Faraday element having a magneto-optical effect. Magnetism generated from the current can be optically detected by the Faraday element, and detected light can propagate through the optical fiber, so that detected magnetic information can be transmitted to the outside. The propagating light has information of the detected magnetism and the detected magnetism has information of the current, so that the current can be detected using the optical CT, and the detected current can be propagated as an optical signal. The present disclosure discloses a technique of diagnosing deterioration of the insulator using only the optical CT. That is, only the optical CT 71 and the optical CT 72 are used as sensors of a single type without using a plurality of types of sensors as in the conventional technology.

In the present disclosure, two optical CTs 71 and 72 are used. As an example, as illustrated in FIG. 3, the first optical CT 71 is disposed on the upstream side of the stator coil 5-1, which is the site to be measured, and the second optical CT 72 is disposed on the downstream side thereof in such a way as to interpose the stator coil 5-1. Each of the optical CT 71 and the optical CT 72 is disposed in such a manner that the Faraday element surrounds the connection line formed of a conductor connecting the stator coil 5-1 and the power supply 6 or the stator coil 5-2.

Each of the optical CT 71 and the optical CT 72 inputs the optical signal by the measured current to the difference calculating circuit 8. The difference calculating circuit 8 is provided with two photoelectric converting circuits and a difference calculating circuit that calculates a difference between electric signals that are the outputs from the respective photoelectric converting circuits. The photoelectric converting circuit can be formed of a photoelectric conversion element, and the difference calculating circuit can be formed of an operational amplifier. The difference calculating circuit 8 outputs an electric signal corresponding to a difference between the two input optical signals.

The electric signal output from the difference calculating circuit 8 is directed to the ground potential via the integrating capacitor 9. Here, capacitance of the integrating capacitor 9 is known.

The insulator deterioration diagnosing device 10 is connected to the integrating capacitor 9 and the power supply 6, and the electric signal acquiring unit 103 of the calculating unit 102 of the insulator deterioration diagnosing device 10 acquires two electric signals of the voltage of the integrating capacitor 9 and the voltage of the power supply 6.

A method of acquiring the electric signals can also be applied to a case other than the stator coil 5-1 closest to a high voltage end by changing a connection position of the optical CT 71 or the optical CT 72, and it is also possible to obtain the total power of the discharge power generated between two or more stator coils and the stator core 1. In other words, the first optical CT 71 and the second optical CT 72 may be arranged in such a way as to interpose any one or more stator coils.

(Hardware)

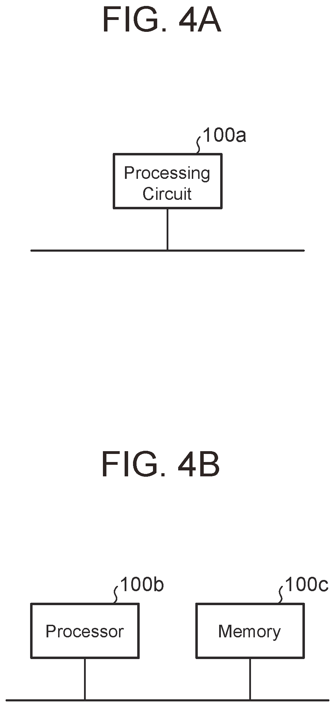

Next, a hardware configuration example of the insulator deterioration diagnosing device 10 will be described with reference to FIGS. 4A and 4B. Each function of the insulator deterioration diagnosing device 10 is implemented by processing circuitry. The processing circuitry may be a dedicated processing circuit 100a as illustrated in FIG. 4A or a processor 100b that executes a program stored in a memory 100c as illustrated in FIG. 4B.

In a case where the processing circuitry is the dedicated processing circuit 100a, the dedicated processing circuit 100a corresponds to, for example, a single circuit, a composite circuit, a programmed processor, a parallel programmed processor, an application specific integrated circuit (ASIC), a field-programmable gate array (FPGA), or a combination thereof. The functions of the insulator deterioration diagnosing device 10 may be implemented by a plurality of different processing circuits, or the functions of the insulator deterioration diagnosing device 10 may be collectively implemented by a single processing circuit.

In a case where the processing circuitry is the processor 100b, the functions of the insulator deterioration diagnosing device 10 are implemented by software, firmware, or a combination of software and firmware. The software and firmware are described as programs and stored in the memory 100c. The processor 100b implements the functions of the insulator deterioration diagnosing device 10 by reading and executing the programs stored in the memory 100c. Herein, examples of the memory 100c include a non-volatile or volatile semiconductor memory such as a random access memory (RAM), a read-only memory (ROM), a flash memory, an erasable programmable read only memory (EPROM), and an electrically erasable programmable read only memory (EEPROM), a magnetic disk, a flexible disk, an optical disk, a compact disc, a mini disc, and a DVD. The memory 100c may be implemented as the same device as the storage device 30.

Note that, some of the functions of the insulator deterioration diagnosing device 10 may be implemented by dedicated hardware and other functions may be implemented by software or firmware. In this manner, the processing circuitry can implement the functions of the insulator deterioration diagnosing device 10 by hardware, software, firmware, or combination thereof.

<Operation>

Next, an operation example of the insulator deterioration diagnosing device 10 and the insulator deterioration diagnosing system Sys. will be described with reference to FIG. 5. A rotary machine is assumed as an example of an electric device, and a description will be given on the basis of a case where a deterioration state of an insulator of the rotary machine is diagnosed.

At step ST1, the diagnosing unit 105 receives, via the input and output device 20, material information regarding the characteristics of the insulator to be diagnosed and information on an operating condition of the rotary machine including the insulator to be diagnosed as an input. The material information regarding the characteristics of the insulator is, for example, information on material composition, thickness and the like of the stator coil insulating film 4, in a case where the stator coil insulating film 4 is to be diagnosed. The information on an operating condition of the rotary machine includes, for example, information on a voltage and a frequency of the AC power supply applied to the rotary machine, and information on the capacitance of the integrating capacitor 9. The diagnosing unit 105 acquires the discharge deterioration relationship information corresponding to the received material information of the insulator out of the discharge deterioration relationship data stored in the storage device 30.

At step ST2, the inflow current to the stator coil 5 (5-1, 5-2,..., and 5-N) and the outflow current from the stator coil 5 are measured using the optical CT 71 and the optical CT 72. This measurement may be performed by a worker arranging the optical CT 71 on the upstream side of the stator coil 5 to be measured, for example, the stator coil 5-1, and the optical CT 72 on the downstream side at the time of diagnosis. The optical CT 71 may be disposed on the upstream side of each stator coil 5 and the optical CT 72 may be disposed on the downstream side in advance, and diagnosis may be always performed. In order to measure any one stator coil 5, the optical CT 71 and the optical CT 72 are arranged in such a way as to be close to the stator coil 5 to be measured. The difference calculating circuit 8 outputs the electric signal corresponding to the difference between the inflow current and the outflow current, and the integrating capacitor 9 accumulates electric charge by the electric signal output from the difference calculating circuit 8. The electric signal acquiring unit 103 of the insulator deterioration diagnosing device 10 acquires the voltage of the integrating capacitor 9 and the voltage of the power supply 6. The electric signal acquiring unit 103 supplies the voltage of the integrating capacitor 9 and the voltage of the power supply 6 that are acquired to the discharge power calculating unit 104.

At step ST3, the discharge power calculating unit 104 calculates the discharge power to be measured from the voltage of the power supply 6 and the voltage of the integrating capacitor 9 on the basis of the V-Q Lissajous method. Here, a method of calculating the discharge power of the partial discharge generated between the stator coil 5-1 and the stator core 1 will be exemplarily described.

Assuming that the voltage at the integrating capacitor 9 is Vm and the capacitance of the integrating capacitor 9 is Cm, electric charge Qm accumulated in the integrating capacitor 9 and a current Im(t) flowing through the integrating capacitor 9 can be expressed by the following formulae (1) and (2), respectively.

$$Q_\mathrm{m} = C_\mathrm{m} V_\mathrm{m} \qquad\qquad (1)$$

$$I_\mathrm{m}(t) = C_\mathrm{m} \frac{dV_\mathrm{m}(t)}{dt} \qquad\qquad (2)$$

The current flowing through the integrating capacitor 9 is equal to the discharge current flowing between the stator coil 5-1 and the stator core 1. A potential difference between the stator coil 5-1 closest to the power supply 6 and the stator core 1 is equal to a voltage Vs of the power supply 6, so that discharge power Ps(t) of the partial discharge generated between the stator coil 5-1 closest to the power supply and the stator core 1 is expressed by the following formula (3).

$$P_\mathrm{s}(t) = V_\mathrm{s}(t) I_\mathrm{s}(t) = V_\mathrm{s}(t) C_\mathrm{m} \frac{dV_\mathrm{m}(t)}{dt} \qquad\qquad (3)$$

Therefore, when the frequency of the power supply 6 is set to 1/T, an average discharge power Ps bar generated between the stator coil 5-1 and the stator core 1 in an AC waveform can be expressed by the following formula (4).

$$\overline{P}_\mathrm{s} = \frac{1}{T} \int_0^T V_\mathrm{s}(t) C_\mathrm{m} \frac{dV_\mathrm{m}(t)}{dt} dt = \frac{1}{T} \int_0^T V_\mathrm{s} C_\mathrm{m} dV_\mathrm{m} = \frac{1}{T} \oint V_\mathrm{s} dQ_\mathrm{m} \qquad\qquad (4)$$

The average discharge power Ps bar calculated by formula (4) corresponds to an area of a Lissajous figure based on the electric charge and voltage.

In this manner, by measuring the voltage of the integrating capacitor 9 and the voltage of the power supply 6 using the integrating capacitor 9 having known capacitance, it is possible to calculate the discharge power of the partial discharge generated between the stator coil 5-1 and the stator core 1. The discharge power calculating unit 104 supplies the calculated discharge power to the diagnosing unit 105.

At step ST4, the diagnosing unit 105 diagnoses the deterioration state of the stator coil insulating film 4 used in the stator coil 5-1 on the basis of the discharge power supplied from the discharge power calculating unit 104.

As exemplarily illustrated in FIG. 6, the deterioration state of the stator coil insulating film 4 depends on the discharge power of the partial discharge to which the stator coil insulating film 4 is exposed. A relationship as in FIG. 6 can be acquired by a sample test in a laboratory. The storage device 30 stores a result obtained by exposing the stator coil insulating film 4 to the partial discharge in a laboratory environment and acquiring a correlation between the deterioration state of the stator coil insulating film 4 and the discharge power of the partial discharge. On the basis of input information from the input device provided in the input and output device 20, the diagnosing unit 105 acquires the discharge deterioration relationship information as illustrated in FIG. 6 and corresponding to the input information from the storage device 30.

The diagnosing unit 105 diagnoses the deterioration state of the stator coil insulating film 4 from the information of the discharge power of the insulating member to be diagnosed and the discharge deterioration relationship information acquired from the storage device 30. As illustrated in FIG. 6, the higher the discharge power, the more advanced the deterioration state becomes, that is, the worse the state of the stator coil insulating film 4.

At step ST5, the diagnosing unit 105 outputs the diagnostic result to the input and output device 20, and the output device of the input and output device 20 displays the diagnostic result.

According to the insulator deterioration diagnosing device 10 or the insulator deterioration diagnosing system Sys. described above, the discharge of the electric device including the insulator is calculated on the basis of the measurement results of the optical CT 71 and the optical CT 72, which are the sensors of a single type, so that the deterioration of the insulator can be diagnosed with a simpler configuration than a conventional configuration.

By arranging the optical CT 71 and the optical CT 72 in the electric device in advance and constantly the electric signal, it is possible to perform diagnosis online without stopping the electric device. In the above description, the integrating capacitor 9 is connected to the output of the difference calculating circuit 8, and the voltage of the integrating capacitor 9 is input to the insulator deterioration diagnosing device 10 and the discharge power to be measured is calculated; however, a numerical value calculating circuit that performs real-time integration operation may be provided in place of the integrating capacitor 9, the output of the difference calculating circuit 8 may be input to the numerical value calculating circuit, and the output of the numerical value calculating circuit may be input to the insulator deterioration diagnosing device 10.

Note that, the embodiments can be combined, and the embodiments can be appropriately modified or omitted.

INDUSTRIAL APPLICABILITY

The insulator deterioration diagnosing device of the present disclosure can be used as a device that diagnoses deterioration of an insulator used in an electric device such as a rotary machine.

REFERENCE SIGNS LIST

1: stator core, 2: stator coil conductor, 3: stator coil insulating member, 4: stator coil insulating film, 5 (5-1 to 5-N) : stator coil, 6: power supply, 71, 72: optical CT, 8: difference calculating circuit, 9: integrating capacitor, 10: insulator deterioration diagnosing device, 20: input and output device, 30: storage device, 100a: processing circuit, 100b: processor, 100c: memory, 102: calculating unit, 103: electric signal acquiring unit, 104: discharge power calculating unit, 105: diagnosing unit

**Claims**

1. An insulator deterioration diagnosing device comprising:

   a calculating unit to calculate, from an electric signal based on an output of a sensor of a single type to measure a current flowing through a conductor of an electric device including an insulator, discharge power of the electric device; and
   a diagnosing unit to diagnose a deterioration state of the insulator on a basis of the calculated discharge power.

2. The insulator deterioration diagnosing device according to claim 1, wherein the diagnosing unit:

   receives material information regarding a characteristic of the insulator;
   acquires discharge deterioration relationship information corresponding to the material information regarding the characteristic of the insulator out of discharge deterioration relationship data indicating a relationship between discharge power and a deterioration state of an insulating material acquired in advance; and

diagnoses the deterioration state of the insulator from the calculated discharge power and the acquired discharge deterioration relationship information.

3. The insulator deterioration diagnosing device according to claim 1 or 2, wherein
the calculating unit calculates the discharge power of the electric device from an area of a Lissajous figure based on electric charge and a voltage.

4. An insulator deterioration diagnosing system, wherein

the sensor of the single type is an optical CT, and
the system comprises:

a power supply to supply AC power to the electric device;
a first optical CT to measure an inflow current flowing into a site to be measured of the electric device;
a second optical CT to measure an outflow current flowing out of the site to be measured;
a difference calculating circuit connected to the first optical CT and the second optical CT, and to output an electric signal corresponding to a difference between the inflow current and the outflow current;
an integrating capacitor connected to the difference calculating circuit and ground; and
the insulator deterioration diagnosing device according to any one of claims 1 to 3 connected to a first connection line to which the AC power is supplied and a second connection line connecting the difference calculating circuit and the integrating capacitor.

5. The insulator deterioration diagnosing system according to claim 4, wherein

the electric device is a rotary machine including: at least one stator coil including a stator coil insulating film to prevent corona discharge; and an iron core to accommodate the at least one stator coil, and
the discharge power of the electric device is discharge power between the stator coil insulating film and the iron core.

6. The insulator deterioration diagnosing system according to claim 5, wherein
the first optical CT and the second optical CT are arranged in such a way as to interpose any one or more stator coils included in the at least one stator coil.

7. The insulator deterioration diagnosing system according to claim 6, wherein
the any one or more stator coils include a single stator coil located closest to the power supply and directly connected to the power supply out of the at least one stator coil.

8. An insulator deterioration diagnosing method by an insulator deterioration diagnosing device including a calculating unit and a diagnosing unit, the method comprising steps of:

by the calculating unit, calculating, from an electric signal based on an output of a sensor of a single type to measure a current flowing through a conductor of an electric device including an insulator, discharge power of the electric device; and
by the diagnosing unit, diagnosing a deterioration state of the insulator on a basis of the calculated discharge power.

# FIG. 1

Sys.

# FIG. 2

# FIG. 3

EP 4 772 893 A1

# FIG. 4A

100a

Processing
Circuit

# FIG. 4B

100b

Processor

100c

Memory

# FIG. 5

```
        ┌─────────┐
        │  Start  │
        └─────────┘
             │
             ▼
┌─────────────────────────────┐
│     Input of Information     │──ST1
└─────────────────────────────┘
             │
             ▼
┌─────────────────────────────┐
│ Measurement of Electric Signal │──ST2
└─────────────────────────────┘
             │
             ▼
┌─────────────────────────────┐
│ Calculation of Discharge Power │──ST3
└─────────────────────────────┘
             │
             ▼
┌─────────────────────────────┐
│ Diagnosis of Deterioration State │──ST4
└─────────────────────────────┘
             │
             ▼
┌─────────────────────────────┐
│  Output of Diagnostic Result │──ST5
└─────────────────────────────┘
             │
             ▼
        ┌─────────┐
        │   End   │
        └─────────┘
```

# FIG. 6

## INTERNATIONAL SEARCH REPORT

| International application No. |
| --- |
| **PCT/JP2023/034386** |

| A. | CLASSIFICATION OF SUBJECT MATTER |
| --- | --- |

*G01R 31/12*(2020.01)i; *G01R 31/34*(2020.01)i
FI:   G01R31/34 A; G01R31/12 A

According to International Patent Classification (IPC) or to both national classification and IPC

| B. | FIELDS SEARCHED |
| --- | --- |

Minimum documentation searched (classification system followed by classification symbols)

G01R31/12; G01R31/34

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 112285496 A (CHINA ELECTRIC POWER RESEARCH INSTITUTE CO., LTD.) 29 January 2021 (2021-01-29) paragraphs [0030]-[0073], fig. 1-3 | 1-2, 8 |
| A | | 3-7 |
| X | JP 2022-109151 A (TOSHIBA MITSUBISHI-ELECTRIC INDUSTRIAL SYSTEMS CORPORATION) 27 July 2022 (2022-07-27) paragraphs [0009]-[0059], fig. 1-5 | 1-2, 8 |
| A | | 3-7 |
| A | JP 2022-38676 A (KABUSHIKI KAISHA MEIDENSHA) 10 March 2022 (2022-03-10) | 1-8 |
| A | JP 2022-181324 A (KABUSHIKI KAISHA TOSHIBA) 08 December 2022 (2022-12-08) | 1-8 |
| A | JP 2020-61797 A (NIPPON STEEL CORPORATION) 16 April 2020 (2020-04-16) | 1-8 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **27 October 2023** | **14 November 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/034386**

| Patent document cited in search report | | | Publication date (day/month/year) | Patent family member(s) | Publication date (day/month/year) |
|---|---|---|---|---|---|
| CN | 112285496 | A | 29 January 2021 | (Family: none) | |
| JP | 2022-109151 | A | 27 July 2022 | (Family: none) | |
| JP | 2022-38676 | A | 10 March 2022 | (Family: none) | |
| JP | 2022-181324 | A | 08 December 2022 | (Family: none) | |
| JP | 2020-61797 | A | 16 April 2020 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022038676 A